# EUROPÄISCHE PATENTANMELDUNG

(11) **EP 4 507 136 A1**
(43) Veröffentlichungstag der Anmeldung: **12.02.2025**
(21) Anmeldenummer: 24189797.4
(22) Anmeldetag: 19.07.2024
(51) Int. Cl.: H01R 13/6466, H05K 1/16, H01R 24/64, H01R 4/2433

(54) **ELEKTRISCHER VERBINDER FÜR EIN DATEN- ODER KOMMUNIKATIONSKABEL**

(30) Priorität: 07.08.2023 DE 102023120883
(71) Anmelder: METZ CONNECT TECH GmbH, 78176 Blumberg (DE)
(72) Erfinder: Pyczak, Andreas, 78247 Hilzingen (DE)
(74) Vertreter: Westphal, Mussgnug & Partner Patentanwälte mbB

(57) **Zusammenfassung**

Elektrischer Verbinder (1) für ein Daten- oder Kommunikationskabel mit folgenden Merkmalen:
- einem Gehäuse (10),
- einer im Gehäuse (10) zumindest teilweise angeordneten Platine (40),
- mit der Platine (40) sind erste (41) und zweite Kontaktelemente (42) verbunden,
- die Platine (40) weist mindestens eine differentielle Leitung (61) auf,
- die differentielle Leitung (61) weist eine erste (64) und eine zweite Leiterbahn (65) auf,
- das erste Kontaktelement (41) ist mit dem zweiten Kontaktelement (42) durch eine Leiterbahn (64, 65) verbunden,
- jede Leiterbahn (64, 65) weist einen Leitungspfad (63) sowie ein erstes (46) und ein zweites Kontaktpad (59) an den Enden des Leitungspfades (63) auf,
- mit der differentiellen Leitung (61) ist eine Kondensator (80)-Induktivitäts (85)-Kombination (kurz C-L-C Kombination) verschaltet,
- ein Kondensator (80) der C-L-C Kombination weist zwei zueinander isolierte leitende Flächen (82) auf,

**gekennzeichnet** durch das weitere Merkmal:
- ein Kondensator (80) der C-L-C Kombination ist mit seiner ersten leitenden Fläche (83) weiter entfernt zum ersten Kontaktpad (46) der ersten Leiterbahn (64) elektrisch angebunden als die zweite leitende Fläche (84) zum ersten Kontaktpad (46) der zweiten Leiterbahn (65).

## Beschreibung

Die Erfindung betrifft einen elektrischen Verbinder gemäß den Merkmalen des Oberbegriffs des Anspruchs 1.

Eine Anpassung der Leitungsimpedanz mittels reaktiver, frequenzabhängiger Elemente wie einer Spule und/oder einem Kondensator werden für eine Verbesserung der Rückflussdämpfung und der Einfügedämpfung in einer Vielzahl von Anwendungen eingesetzt. Dabei sind stets die normativen Anforderungen an die Rückflussdämpfung und die Einfügedämpfung zu beachten. Beispielsweise sind zur Verbesserung dieser Eigenschaften Anordnungen bekannt, welche zwei parallele Kapazitäten mit einer in Serie geschalteten Spule besitzen.

Ein Kommunikationsverbinder, der eine Verbesserung der Rückflussdämpfung und Einfügedämpfung durch Verwendung der genannten Anordnung aufweist, ist beispielsweise aus der Schrift US 9206569 B2 bekannt. In dieser Schrift ist ein Steckverbinder beansprucht, der in einem ersten Bereich eine erste Impedanz, in einem zweiten Bereich eine zweite Impedanz und im dritten Bereich eine dritte Impedanz aufweist, sodass sich ein Maximum im Rückflussdämpfungsspektrum ausbildet. Zudem ist offenbart, dass die Impedanzen als Ganzes zeitlich zueinander verzögert angeordnet sein können, um ebenfalls eine Verbesserung der Einfügedämpfung und/oder Rückflussdämpfung zu erreichen.

Um mehr Optimierungsmöglichkeiten zur Verbesserung der Einfügedämpfung, der Rückflussdämpfung der Bandbreite sowie eine Verschiebung der Impedanzwerte in einen für die Realisierung bevorzugten Bereich zu erhalten, ist die bisherige Anzahl an Freiheitsgraden nicht ausreichend.

Der vorliegenden Erfindung liegt das Problem zugrunde hier Abhilfe zu schaffen.

Dieses Problem wird durch einen elektrischen Verbinder mit den Merkmalen des Patentanspruchs 1 gelöst.

Vorteilhafte Ausgestaltungen und Weiterbildungen der Erfindung sind in den abhängigen Ansprüchen angegeben.

Erfindungsgemäß ist demnach ein elektrischer Verbinder mit einem Gehäuse, wobei im Gehäuse zumindest teilweise eine Platine angeordnet ist, wobei mit der Platine erste und zweite Kontaktelemente verbunden sind. Die Platine weist mindestens eine differentielle Leitung auf, wobei eine differentielle Leitung eine erste und zweite Leiterbahn aufweist. Dabei ist das erste Kontaktelement mit einem zweiten Kontaktelement durch eine Leiterbahn verbunden. Eine Leiterbahn weist einen Leitungspfad sowie ein erstes und ein zweites Kontaktpad an den Enden des Leitungspfades auf. Mit der differentiellen Leitung ist eine Kondensator-Induktivitäts-Kombination (kurz C-L-C Kombination) verschaltet, wobei ein Kondensator zwei zueinander isolierte leitende Flächen aufweist. Der Kondensator der C-L-C Kombination ist mit seiner ersten leitenden Fläche weiter entfernt zum ersten Kontaktpad der ersten Leiterbahn elektrisch angebunden als die zweite leitende Fläche zum ersten Kontaktpad der zweiten Leiterbahn.

Die Entfernung von einem ersten Kontaktpad zu einer leitenden Fläche des ersten C der C-L-C Kombination entlang einer elektrischen Verbindung ist hier und im Folgenden als Wegstrecke definiert. Innerhalb einer differentiellen Leitung sind zum Anschluss des ersten C zwei Wegstrecken ausgebildet. Die kürzere dieser beiden Wegstrecken ist hier und im Folgenden als kürzere Wegstrecke definiert. Die längere der beiden Wegstrecken ist hier und im Folgenden als längere Wegstrecke definiert. Die Differenz aus längerer und kürzerer Wegstrecke ist hier und im Folgenden als Wegstreckendifferenz definiert.

Eine C-L-C Kombination wird oft auch als pi-Netzwerk oder Collins-Filter bezeichnet. Das Netzwerk weist zwei Parallel-Kapazitäten, welche vorzugsweise als Kondensatoren ausgebildet sind und eine Serien-Induktivität, welche vorzugsweise als Spule ausgebildet ist, auf. Das Netzwerk ist in zwei Teile gliederbar. Der erste Teil weist die Impedanzkombination einer parallel geschalteten Kapazität mit einer in Serie geschalteten Spule auf. Dieser erste Teil hat Tiefpass-Charakteristik. Der zweite Teil weist eine parallel geschaltete Kapazität auf. Mit diesem zweiten Teil ist ein zusätzlicher Freiheitsgrad zur Optimierung der Bandbreite, der Einfügedämpfung oder der Rückflussdämpfung vorhanden. Das Netzwerk muss keineswegs die Gestalt einer C-L-C Anordnung aufweisen. Beispielsweise kann die im ersten Teil parallel angeordnete Kapazität durch eine parallel geschaltete Induktivität ersetzt werden, wodurch dieser Teil Hochpass-Charakteristik aufweist. Je nach Anwendungsfall ist jede Impedanz innerhalb des Netzwerks durch eine andere Impedanz mit anderer Wirkung ersetzbar.

Des Weiteren ist es möglich zwei Bauteile gleicher Wirkung parallel oder in Reihe anzuordnen. Dabei bleiben die Charakteristika des entsprechenden Netzwerks erhalten. Beispielsweise kann ein C der C-L-C Anordnung durch zwei oder mehrere parallele oder serielle Kondensatoren ausgestaltet sein. Zudem ist es möglich Bauteile unterschiedlicher Wirkung parallel oder in Reihe anzuordnen wie beispielsweise Kondensatoren und Spulen aber auch Kondensatoren mit unterschiedlichen Kapazitäten oder Spulen mit unterschiedlichen Induktivitäten.

Neben der oben genannten Zweiteiligkeit des Netzwerkes, welches vor allem auf die Wirkung abzielt, ist es möglich, die C-L-C Anordnung in drei räumlich voneinander verschiedene Bereiche einzuteilen. Im ersten Leiterbahnabschnitt ist eine erste Kapazität mit der ersten und zweiten Leiterbahn der differentiellen Leitung verbunden. Im zweiten Leiterbahnabschnitt ist eine Induktivität ausgebildet, die entweder mit der ersten Leiterbahn und/oder der zweiten Leiterbahn verbunden ist. Im dritten Leiterbahnabschnitt ist eine zweite Kapazität mit der ersten und zweiten Leiterbahn der differentiellen Leitung verbunden, wobei der dritte Leiterbahnabschnitt entlang einer elektrischen Verbindung weiter von einem ersten Kontaktpad angeordnet ist, als der zweite Leiterbahnabschnitt. Der zweite Leiterbahnabschnitt entlang einer elektrischen Verbindung ist weiter von einem ersten Kontaktpad angeordnet, als der erste Leiterbahnabschnitt.

Einfügedämpfung und Rückflussdämpfung stehen in einem Zusammenhang zueinander. Insofern ist es wichtig eine möglichst große Anzahl an Freiheitsgraden zu besitzen, um eine etwaige Verschlechterung durch eine Anpassung eines anderen Freiheitsgrades ausgleichen zu können. Ein weiterer Freiheitsgrad wird erfindungsgemäß bereitgestellt, indem die Wegstrecke auf beiden Leiterbahnen variiert wird. Eine größere Wegstrecke bedingt einen größeren induktiven Anteil auf der ersten oder zweiten Leiterbahn. Damit ist jede Leiterbahn für sich individuell einstellbar, wodurch etwaige Unsymmetrien ausgeglichen werden können. Es ist zudem möglich Unsymmetrien innerhalb der differentiellen Leitung gezielt auszubilden, wodurch die Position an der Reflexionen auftreten veränderbar ist.

Häufig ist die Ausgestaltung diskreter Bauteile, die Breite der Leitung, die Substrathöhe und Ähnliches mangels Platz oder aus fertigungsgründen auf der Platine nicht ausgestaltbar. Um realisierbare und kostengünstige Impedanzen hinsichtlich der geometrischen Abmaße auf der Platine platzieren zu können, ist eine einfach Verlängerung der Wegstrecke zumeist einfacher zu bewerkstelligen, als diese durch zusätzliche Bauteile oder aufwendige Strukturänderungen der Bauteile auf der Platine auszubilden.

Aufgrund normativer Anforderung ist es unter Umständen nötig, eine zusätzliche Kapazität zwischen der ersten und zweiten Leiterbahn einzufügen.

Gemäß einer weiteren vorteilhaften Ausgestaltung der Erfindung ist ein C, vorzugsweise das zweite C, der C-L-C Kombination mit einem Anschluss an einem zweiten Kontaktpad der ersten Leiterbahn und mit seinem anderen Anschluss an den Leitungspfad der zweiten Leiterbahn angeschlossen. Das zweite C kann jedoch auch über einen Anschluss mit dem Leitungspfad der ersten Leiterbahn oder mit dem anderen Anschluss an das zweite Kontaktpad der zweiten Leiterbahn angeschlossen werden. Dabei ist stets die Wegstrecke zur ersten leitenden Fläche des zweiten C länger als die Wegstrecke zur zweiten leitenden Fläche des zweiten C.

Betrachtet wird ein zu übertragenes Signal, welches sich ausgehend von den ersten Kontaktelementen über die ersten Kontaktpads und den Leitungspfad ausbreitet. Ein Signal breitet sich auf einer elektrischen Leitung mit annähernd Lichtgeschwindigkeit aus. Damit ist die Geschwindigkeit des Signals endlich und eine längere Wegstrecke bedingt automatisch eine Verzögerung des Signals über dem Übertragungspfad. Da die Wegstrecke zu der ersten leitenden Fläche deutlich länger ist, erreicht das zu übermittelnde Signal selbige deutlich später, als die zweite leitende Fläche, welche direkt mit dem Leitungspfad verbunden ist. Das Signal passiert zuerst das zweite Kontaktpad bevor es die zweite leitende Fläche über den Anschluss erreicht.

Da häufig mehrere zweite Kontaktelemente, welche direkt mit den zweiten Kontaktpads verbunden sind, nebeneinander angeordnet werden, können die zweiten Kontaktelemente zueinander eine kapazitive Kopplung aufweisen. Diese muss bei der Auslegung der Impedanzen der C-L-C Anordnung sowie der Länge der Wegstrecke mitberücksichtigt werden.

Vorteilhafterweise ist die erste leitende Fläche des C entlang einer elektrischen Verbindung mindestens 5 %, vorzugsweise 20 %, besonders bevorzugt 50 %, im besonderen bevorzugt 90 % der kürzeren Wegstrecke weiter entfernt zu einem ersten Kontaktpad angeordnet als die zweite leitende Fläche des C.

In einer weiteren günstigen Ausgestaltung der Erfindung ist ein C der C-L-C Kombination als Kondensator ausgebildet. Kondensatoren sind auf Platinen einfach zu realisierende Bauteile. Die Kapazität der Kondensatoren ist von einer Vielzahl von Faktoren abhängig. Auf Platinen ist die Kapazität bei Kondensatoren einfach und kostengünstig über die Größe und Anordnung der leitenden Flächen des Kondensators einstellbar.

Vorteilhafterweise ist der Kondensator als Plattenkondensator ausgebildet, wobei der Plattenkondensator zwei parallel zueinander angeordnete leitende Platten aufweist und zwischen den Platten das Platinensubstrrat als Dielektrikum dient.

Gemäß einer besonders bevorzugten Ausgestaltung der Erfindung ist der Kondensator als Interdigitalkondensator ausgebildet, wobei der Interdigitalkondensator erste Stifte und zweite Stifte aufweist, wobei die ersten Stifte und zweiten Stifte abwechselnd ineinander greifen. Die Stifte des Interdigitalkondensators können auf einer Platinenlage ausgebildet sein. Dies kann dazu führen, dass weniger Platinenlagen gestellt werden müssen, was die Kosten deutlich reduziert.

Bei einer C-L-C Anordnung ist es möglich, dass eine der Kapazitäten als Plattenkondensator und die andere Kapazität als Interdigitalkondensator ausgebildet ist. Zudem kann eine leitende Fläche eines Kondesators mit zwei oder mehreren anderen leitenden Flächen von zwei oder mehreren Kondensatoren in Wechselwirkung treten. Hierbei ist eine Optimierung der Einfügedämpfung, der Rückflussdämpfung und eine Verminderung oder Vergrößerung des Übersprechens unterschiedlicher differentieller Leitungen möglich.

In einer besonders günstigen Ausgestaltung der Erfindung ist das L der C-L-C Kombination aus genau einer Induktivität ausgebildet, wobei die Induktivität mit dem Leitungspfad der ersten Leiterbahn oder mit dem Leitungspfad der zweiten Leiterbahn in Serie geschaltet ist. Durch die Anordnung einer Induktivität auf einer der beiden Leiterbahnen der differentiellen Leitung werden weniger Bauteile eingesetzt, was Vorteile hinsichtlich des Platzes und der Kosten mit sich bringt. Zudem wird eine Leiterbahn induktiv stärker belastet, wodurch etwaige Unsymmetrien ausgeglichen werden.

Besonders bevorzugt ist das L der C-L-C Kombination aus zwei voneinander räumlich getrennten Induktivitäten ausgebildet, wobei die Induktivitäten jeweils mit dem Leitungspfad der ersten Leiterbahn und der zweiten Leiterbahn in Serie geschaltet sind. Dadurch, dass mit beiden Leiterbahnen einer differentiellen Leitung Induktivitäten verbunden sind, ist eine punktuelle Einstellung der induktiven Belastung einer Leiterbahn einstellbar.

Gemäß einer bevorzugten Ausgestaltung der Erfindung ist die Induktivität durch einen mäanderförmigen Verlauf des Leitungspfades oder der Leitungspfade ausgebildet. Durch den mäanderförmigen Verlauf des Leistungspfades ist die Ausbildung der Induktivität billig ausgestaltbar. Es sind keine zusätzlichen Bauteile erforderlich. Dies ist insofern von Vorteil, da Bauteile mit induktivem Charakter zumeist teuer in der Anschaffung sind. Zudem ist die Fehleranfälligkeit reduziert, da kein Bauteil auf der Platine fixiert und elektrisch kontaktiert werden muss.

In einer besonders günstigen Ausgestaltung der Erfindung sind der mäanderförmige Verlauf des Leitungspfades der ersten Leiterbahn auf einer Platinenlage und der mäanderförmige Verlauf des Leitungspfades der zweiten Leiterbahn auf einer anderen Platinenlage angeordnet.

Vorteilhafterweise weisen der mäanderförmige Verlauf des Leitungspfades der ersten und zweiten Leiterbahnen nahezu dieselbe Gestalt auf, wobei die Verläufe nahezu vollständig überlappend zueinander angeordnet sind. Die beiden Leiterbahnen können dabei auch vollständig überlappend zueinander angeordnet sein. Durch die gleiche Ausgestaltung der Induktivitäten auf beiden Leiterbahnen einer differentiellen Leitung und einer Ausgestaltung derart, dass die Leiterbahnen nahezu vollständig überlappend zueinander angeordnet sind, werden beide Leiterbahnen nahezu gleich induktiv belastet. Da die beiden Induktivitäten nahezu vollständig überlappend angeordnet sind, beeinflussen diese sich gegenseitig, wodurch ein weiterer Freiheitsgrad, nämlich die Anordnung der Induktivitäten zueinander, gegeben ist. Vorteilhafterweise beträgt die Länge des mäanderförmigen Verlaufs des Leitungspfades mindestens 20 Prozent der Gesamtlänge des Leitungspfades. Die Gesamtlänge des Leitungspfades ist definiert als der kürzeste Weg entlang einer elektrischen Verbindung zwischen erstem und zweitem Kontaktpad einer Leiterbahn.

In einer weiteren günstigen Ausgestaltung der Erfindung ist die Induktivität durch Variation der Leiterbahnbreite, der Substratdicke oder dem Abstand der ersten und zweiten Leiterbahn veränderbar. Die Induktivität einer Leiterbahn hängt von verschiedenen Faktoren ab. Beispielsweise ist die Impedanz der Leiterbahn größer, umso dünner die Leiterbahnbreite ist und vice versa.

Gemäß einer besonders bevorzugten Ausgestaltung der Erfindung ist ein erstes C in einem ersten Leiterbahnabschnitt angeordnet, wobei das L in einem zweiten Leiterbahnabschnitt angeordnet ist, wobei das zweite C in einem dritten Leiterbahnabschnitt angeordnet ist, wobei der erste Leiterbahnabschnitt das erste Kontaktpad und den Leitungspfad bis zur Induktivität umfasst, wobei der zweite Leiterbahnabschnitt zwischen Anfang und Ende der in Serie geschalteten Induktivität angeordnet ist, wobei der dritte Leiterbahnabschnitt das zweite Kontaktpad und den Leitungspfad von dem Ende der Induktivität und das zweite Kontaktpad umfasst.

In einer besonders günstigen Ausgestaltung der Erfindung sind vier differentielle Leitungen auf der Platine ausgebildet. Vorzugsweise ist der elektrische Verbinder als Steckbuchse ausgebildet, insbesondere als RJ45-Steckbuchse. RJ45-Steckbuchsen weisen topologiebedingt vier differentielle Leitungen mit jeweils zwei Leiterbahnen auf. Der elektrische Verbinder kann auch als Steckverbinder oder Anschlussdose ausgebildet sein. Vorteilhafterweise ist das Gehäuse zumindest teilweise aus einem leitenden Material, vorzugsweise als Metalldruckgussteil, insbesondere als Zinkdruckgussteil, ausgestaltet. Damit verbessert sich das EMV Verhalten des elektrischen Verbinders und die Störaussendung erheblich. Zudem ist der elektrische Verbinder durch das Metallgehäuse robuster ausgestaltet, was ihn im Vergleich zu einem elektrischen Verbinder mit einem Kunststoffgehäuse weniger anfällig gegenüber mechanischen Beanspruchungen macht.

Die Montage des elektrischen Verbinders kann in einfacher Weise ohne aufwändiges Werkzeug oder Hilfsmittel erfolgen. Hierfür werden die Einzeladern des anzuschließenden Kabels in ein Ladestück eingeführt, wo sie an dessen in Steckrichtung weisender Stirnseite austreten. An dieser Stirnseite können die Adern abgeschnitten werden. Eine Anpassung der Länge der freien Enden der Adern ist bei der Montage nicht erforderlich. Das anzuschließende Kabel kann durch eine Zugentlastung geklemmt sein, so dass die Adern in dem Ladestück fixiert sind und sich bei der weiteren Montage nicht verschieben können. Das Ladestück ist vorzugsweise aus einem isolierenden Werkstoff, insbesondere aus einem Kunststoffspritzgussteil ausgebildet.

Der elektrische Verbinder ist für sogenannte Multiport-Buchsen geeignet, bei welchen mehrere Buchsen in einem zweidimensionalen Raster angeordnet sind.

Als ein C ist im Vorherigen, hier und im Folgenden ein Kondensator definiert.

Überlappung ist im Vorherigen, hier und im Folgenden so definiert, dass mindestens ein Vektor existiert, der entlang einer einzigen Raumrichtung verlaufend zwei im Raum angeordnete Flächen schneidet. Die Flächen sind sodann überlappend zueinander angeordnet.

Im Folgenden wird ein Ausführungsbeispiel der Erfindung anhand von Figuren erläutert. Es zeigen:
- Fig. 1: eine perspektivische Ansicht eines elektrischen Verbinders in Explosionsdarstellung mit Gehäuse, Platine, Ladestück und Kontaktelementen,
- Fig. 2: eine perspektivische Ansicht der Platine aus Fig. 1,
- Fig. 3: eine perspektivische Ansicht einer differentiellen Leitung der Platine aus Fig. 2,
- Fig. 4: eine perspektivische Ansicht der ersten Leiterbahn der differentiellen Leitung aus Fig. 3,
- Fig. 5: eine perspektivische Ansicht der zweiten Leiterbahn der differentiellen Leitung aus Fig. 3, und
- Fig. 6: eine perspektivische Ansicht der differentiellen Leitung der Platine aus Fig. 2 mit Interdigitalkondensator.
In den nachfolgenden Figuren bezeichnen gleiche Bezugszeichen gleiche Teile mit gleicher Bedeutung.

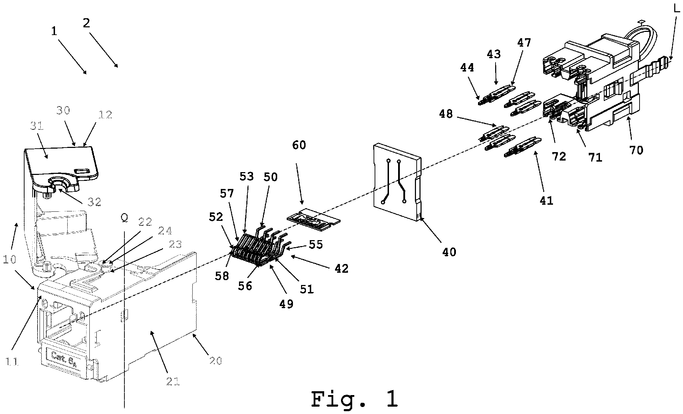

Fig. 1 zeigt einen elektrischen Verbinder 1, welcher als Steckbuchse 2 ausgebildet ist. Die Steckbuchse 2 weist ein Gehäuse 10 auf, welches ein Gehäusevorderteil 20 und Gehäusehinterteil 30 aufweist. Die Vorderseite der Steckbuchse ist als diejenige Seite definiert, welche das Steckgesicht (nicht gezeigt) beispielsweise eines RJ45-Steckverbinders, aufnimmt. Die Hinterseite der Steckbuchse 2 ist als diejenige Seite definiert, durch welche ein Kabel (nicht gezeigt) in die Steckbuchse 2 einführbar ist und deren Einzeladern anschließend in das Ladestück 40 eingelegt werden können. An der Stirnseite des Gehäusevorderteils 20 ist die Vorderseite 11 der Steckbuchse 2 ausgebildet. Das Gehäusehinterteil 12 bildet die Hinterseite 12 der Steckbuchse 2 aus. Neben der Vorderseite bildet das Gehäusevorderteil vier Seitenflächen 21 aus, wobei eine Seitenfläche 21 länger ausgebildet ist als die anderen drei Seitenflächen 21. Das Gehäusehinterteil 30 ist U-förmig ausgebildet und weist drei Seitenflächen 31 auf, wobei die längere Seitenfläche 21 des Gehäusevorderteils 20 sich im zusammengesetzten Zustand in die fehlende Seitenfläche 31 des Gehäusehinterteils 30 einschmiegt.

Das Gehäusehinterteil 30 ist am Gehäuseoberteil 20 schwenkbar gelagert. Hierfür weist das Gehäusehinterteil 30 an zwei Seitenflächen 31 eine Einbuchtung 32 auf, wobei diese Einbuchtung 32 die Form einen Halbkreises aufweist. Die Einbuchtung 32 kann ebenfalls die Form einen Ovals oder Kreises ausbilden. Die Einbuchtung 32 weist von der Vorderseite 11 der Steckbuchse 2 aus gesehen einen konischen, trapezförmigen oder parallelogrammförmigen Verlauf auf.

Das Gehäusevorderteil 20 weist an zwei Seitenflächen 21 eine Verbindungselement 22 auf. Das Verbindungselement 22 setzt sich aus einem Stab 23 und einer Platte 24 zusammen. Im zusammengesetzten Zustand greift das Verbindungselement 22 des Gehäusevorderteils 20 in die Einbuchtung 32 des Gehäusehinterteils 30 ein und ist drehbar gelagert. Das Gehäusehinterteil 30 kann zudem in das Gehäusevorderteil 20 eingeklipst, mittels einer Schraube fixiert, geklebt oder aufgepresst werden.

Das Gehäusevorderteil 20 und das Gehäusehinterteil 30 sind vorzugsweise aus einem leitenden Material beispielsweise aus Blech oder einem Metalldruckgussteil, insbesondere einem Zinkdruckgussteil, ausgebildet. Die Steckbuchse 2 weist durch die leitenden Eigenschaften des Materials des Gehäuses 10 eine elektrische Schirmung auf. Die elektromagnetische Verträglichkeit der Steckbuchse 2 verbessert sich dadurch signifikant. Zudem wird die Störaussendung der Steckbuchse 2 und die Beeinflussung durch die Steckbuchse 2 gegenüber anderen elektronischen Geräten verringert. Zudem ist die Steckbuchse 2 robuster gegenüber äußeren mechanischen Einflüssen als beispielsweise eine Steckbuchse 2, welche ein Gehäuse 10 aus Kunststoff besitzt.

Innerhalb des Gehäuses 10 ist zumindest teilweise eine Platine 40 angeordnet, wobei mit der Platine 40 erste Kontaktelemente 41 und zweite Kontaktelemente 42 verbunden sind. Die ersten Kontaktelemente 41 sind als Schneidklemmen 43 ausgebildet. Schneidklemmen 43 sind zumindest teilweise aus einem leitenden Material ausgebildet. Die Schneidklemmen 43 weisen einen Fuß 44 auf, welcher durch eine erste Kontaktöffnung 45 in der Platine 40 geführt wird und mit dem ersten Kontaktpad 46 elektrisch kontaktierbar ist. Die Kontaktierung erfolgt mittels einer Lötung oder einer Pressung. Zudem bilden die Schneidklemmen 43 eine Durchführöffnung 47 aus, durch welche die Isolierung der Einzeladern eines Kabels bei der Montage der Steckbuchse 2 abisoliert wird und sich eine elektrische Verbindung zwischen Schneidklemme 43 und Einzelader einstellt.

Insgesamt sind acht Schneidklemmen 43 mit der Platine 40 verbunden. Es können mehr oder weniger Schneidklemmen 43 mit der Platine 40 verbunden sein. Die Schneidklemmen 43 können in Reihen angeordnet sein. Vorzugsweise in vier Reihen. Die einzelnen Schneidklemmen 43 einer Reihe können zu anderen Schneidklemmen 43 anderer Reihen versetzt angeordnet sein. Die Schneidklemmen 43 bilden eine Schneidklemmenfläche 48 aus. Die Schneidklemmenflächen 48 können auf einer Linie, parallel oder in einem Winkel zueinander angeordnet sein. Die Schneidklemmenflächen 48 einer Schneidklemmenreihe kann zu einer anderen Schneidklemmenreihe parallel oder in einem Winkel angeordnet sein. Die Platine 40 ist quer zur Steckrichtung im Gehäuse 10 angeordnet. Die Platine 40 wird vorzugsweise im THR-Verfahren (Through Hole Reflow) verlötet.

Die zweiten Kontaktelemente 42 sind als Steckkontakte 49 ausgebildet. Ein Steckkontakt 49 weist vier unterschiedliche Teilabschnitte auf, welche über drei Verbindungsabschnitte mit einander elektrisch verbunden sind. Die Teilabschnitte sind stabförmig ausgebildet und verlaufen parallel zur Längsachse L der Steckbuchse 2. Die Querachse Q ist orthogonal zur Längsachse L angeordnet.

Entlang der Querachse Q sind die Teilabschnitte eines Steckkontakts 49 auf vier unterschiedlichen Ebenen angeordnet, wobei eine Ebene als eine im Raum unendlich ausgedehnte zweidimensionale Fläche definiert ist, wobei die dritte Dimension im Raum die Querachse Q ist. Der Teilabschnitt eins 50 ist durch die zweite Kontaktöffnung 54 der Platine 40 durchschiebbar und wird mittels einer Lötung oder einer Pressung mechanisch befestigt und elektrisch mit der Platine 40 kontaktiert. Die Teilabschnitte eins 50 der einzelnen Steckkontakte 49 können auf unterschiedlichen Ebenen angeordnet sein. Vorzugsweise sind die Teilabschnitte eins 50 in Reihen angeordnet, wobei eine Reihe bedeutet, dass die Teilabschnitte eins 50 auf einer Ebene angeordnet sind. Die ersten Teilabschnitte 50 können auch in einer Reihe oder in mehr als zwei Reihen angeordnet sein. Teilabschnitt eins 50 und Teilabschnitt zwei 51 werden über ein erstes Verbindungselement 55 verbunden.

Der zweite Teilabschnitt 51 liegt auf einer anderen Ebene entlang der Querachse Q als der erste Teilabschnitt 50. Das zweite Verbindungselement 56 verbindet elektrisch den zweiten Teilabschnitt 50 mit dem Teilabschnitt drei 52. Das zweite Verbindungselement 56 ist die Kontaktstelle 58 an der sich der eingesteckte Steckverbinder (nicht gezeigt) und die Steckbuchse 2 elektrisch im eingesteckten Zustand kontaktieren. Teilabschnitt drei 52 stellt eine elektrische Verbindung zu einer Kompensationsplatine 60 her. Der Verbindungsweg drei 57 verbindet Teilabschnitt drei 52 mit dem Teilabschnitt vier 4. Die Teilabschnitte zwei 51, drei 52 und vier 53 liegen jeweils auf einer Ebene in der Querachse Q. Die Steckkontakte können mehr oder weniger als vier Teilabschnitte aufweisen. Zudem können die einzelnen Teilabschnitte ebenfalls in unterschiedlichen Ebenen angeordnet sein.

Eine Kompensationsplatine 60 ist im Bereich der Kontaktstelle 58 angeordnet, wobei die Kontaktstelle 58 den Kontaktbereich der Steckkontakte 49 der Steckbuchse 2 mit den Steckkontakten des Steckverbinders (nicht gezeigt) im verbundenen Zustand darstellt. Auf dieser sind Impedanzen derart angeordnet, dass ein Übersprechen zwischen unterschiedlichen differentiellen Leitungen 61 oder Leiterbahnen 64, 65 der gleichen differentiellen Leitung 61 je nach Anwendungsfall vergrößert oder verkleinert wird.

Innerhalb des Gehäuses ist zumindest teilweise ein Ladestück angeordnet. Das Ladestück ist aus einem nichtleitenden Material ausgebildet, vorzugsweise aus Kunststoff, insbesondere aus einem Kunststoffspritzgussteil. Beim Kabel welches durch die Hinterseite 12 der Steckbuchse 2 eingeführt wird, werden die Einzeladern des Kabels aufgetrennt, die zuvor beispielsweise paarweise verdrillt gewesen sind und in die Halteklemmen 71 des Ladestücks 70 eingesetzt und mechanisch fixiert werden. Die Einzeladern können mittels einer Schraube, eines Klebemittels oder vorzugsweise mittels einer Klemmung mechanisch am Ladestück 70 fixiert werden. Das Ladestück 70 weist Aushöhlungen 72 auf, in welche die Schneidklemmen 43 beim Zusammensetzen eindringen und die Einzeladern des eingeführten Kabels abisolieren und eine elektrische Verbindung herstellen. Das Gehäuse 10 und das Ladestück 70 können mittels Schnapp-Füge-Verbindungen miteinander verrasten, so dass keine zusätzlichen Hilfsmittel, wie z.B. Verschraubungen oder dergleichen zum Fixieren erforderlich sind. Die Schneidklemmen 43 können entlang der Querachse in verschiedenen Ebenen in Reihen, einzeln oder paarweise angeordnet sein.

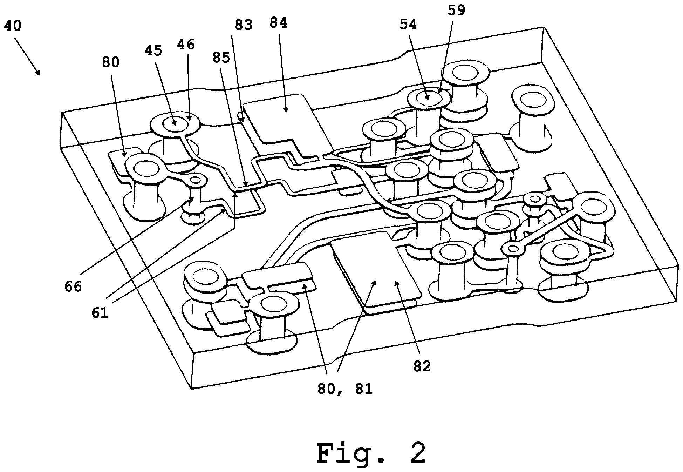

Fig. 2 zeigt die Platine 40 aus Fig. 1. Die Platine 40 weist vier differentielle Leitungen 61 auf. Eine differentielle Leitung 61 besteht aus einer ersten Leiterbahn 64 und einer zweiten Leiterbahn 65, wobei jede Leiterbahn 64, 65 ein erstes Kontaktpad 46, ein zweites Kontaktpad 59 und einen Leitungspfad 63 aufweist. Der Leitungspfad 63 stellt eine elektrische Verbindung zwischen dem ersten Kontaktpad 46 mit dem zweiten Kontaktpad 59 her. Das erste Kontaktelement 41, welches vorzugweise als Schneidklemme 43 ausgebildet ist, ist direkt mit dem ersten Kontaktpad 46 elektrisch verbunden. Das zweite Kontaktelement 42, was vorzugsweise als Steckkontakt 49 ausgebildet ist, ist direkt mit dem zweiten Kontaktpad 59 elektrisch verbunden. Die Platine 40 kann als PTFE oder FR-4 Material ausgebildet sein. Die Platine 40 kann dabei als flexible oder starre Platine 40 ausgebildet sein. Die Platine 40 ist vierlagig ausgebildet. Die Platine 40 kann weniger oder mehr als vier Platinenlagen aufweisen. Die einzelnen Leiterbahnen 64, 65 können auf unterschiedlichen Platinenlagen über Vias 66 oder die ersten 45 und zweiten 54 Kontaktöffnungen, welche vorzugsweise verkupfert sind, geführt werden. Zudem sind Kondensatoren 80 auf der Platine 40 ausgebildet.

Die Kondensatoren 80 sind vorzugsweise als Plattenkondensatoren ausgebildet. Hierfür stehen sich leitende Flächen 82 ähnlicher Gestalt auf unterschiedlichen Platinenlagen gegenüber. Dabei kann es sich um die nächstliegende Platinenlage oder eine gänzlich andere Platinenlage handeln. Die Kondensatoren 80 können ebenfalls als Interdigitalkondensatoren ausgebildet sein, wobei diese zumeist auf einer Platinenlage angeordnet sind. Die Kondensatoren werden dafür eingesetzt, um Übersprechen zu verringern oder zu vergrößern oder die Einfügedämpfung, die Rückflussdämpfung und die Bandbreite zu optimieren. Zudem weisen die erste Leiterbahn 64 und die zweite Leiterbahn 65 der differentiellen Leitung 61 jeweils eine Induktivität 85 auf. Die Induktivität 85 ist als Spule ausgebildet, wobei diese durch einen mäanderförmigen Verlauf des Leitungspfades 63 realisiert ist.

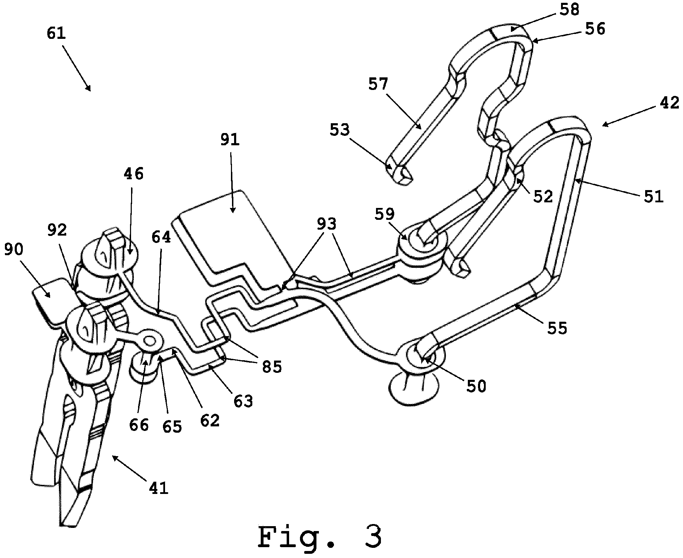

In Fig. 3 ist die differentielle Leitung 61 der Platine 40 aus Fig. 1 und 2 abgebildet. Zusätzlich zur differentiellen Leitung 61 sind die jeweiligen ersten Kontaktelemente 41, welche vorzugsweise als Schneidklemmen 43 ausgebildet sind und die zweiten Kontaktelemente 42, welche vorzugsweise als Steckkontakte 49 ausgebildet sind, abgebildet. Auf die differentielle Leitung 61 wirkt eine C-L-C Kombination. Das erste C 90 ist in einem ersten Leiterbahnabschnitt L1 angeordnet. Der erste Leiterbahnabschnitt L1 umfasst das erste Kontaktpad 46 und den Leitungspfad 63 bis zur Induktivität 85. Der zweite Leiterbahnabschnitt L2 ist zwischen Anfang und Ende der in Serie geschalteten Induktivität 85 ausgebildet. Der dritte Leiterbahnabschnitt L3 umfasst das zweite Kontaktpad 59 und den Leitungspfad 63 ab dem Ende der Induktivität 85 bis zum zweiten Kontaktpad 59, wobei das Ende der Induktivität 85 der Teil der Induktivität 85 ist, der am weitesten von dem ersten Kontaktpad 46 entlang einer elektrischen Verbindung angeordnet ist.

Das erste C 90 ist als Plattenkondensator 81 ausgebildet, wobei der Kondensator zwei leitende Flächen 82 aufweist, welche auf unterschiedlichen Platinenlagen nahezu vollständig überlappend zueinander angeordnet sind. Das erste C 90 ist mit den jeweiligen Leiterbahnen 64, 65 mit dem ersten Leiterbahnabschnitt L1 über Stichleitungen 92 verbunden. Die Stichleitungen 92 sind diejenigen Leitungen, welche nicht im direkten Signalpfad liegen. Das erste C 90 kann mit einer Stichleitung 92 mit dem Leitungspfad 63 der einen Leiterbahn 64, 65 innerhalb des ersten Leiterbahnabschnitts L1 einer differentiellen Leitung 61 und mit der anderen Stichleitung 92 mit dem Leitungspfad 63 oder einem ersten Kontaktpad 46 der anderen Leiterbahn 64, 65 des ersten Leiterbahnabschnitts L1 einer differentiellen Leitung 61 verbunden sein. Innerhalb des ersten Leiterbahnabschnitts L1 der zweiten Leiterbahn 65 ist ein Via 66 Teil des Leitungspfades 63. Vias 66 können auch im Leitungspfad der ersten Leiterbahn 64 oder in beiden Leiterbahnen 64, 65 der differentiellen Leitung 61 oder in einem anderen Leiterbahnabschnitt ausgebildet sein.

Die Induktivität 85 der C-L-C Kombination ist mit dem zweiten Leiterbahnabschnitt L2 elektrisch verbunden, wobei die Induktivität 85 durch zwei Spulen ausgebildet ist. Jeweils eine Spule ist mit dem Leitungspfad 63 der ersten Leiterbahn 64 oder der zweiten Leiterbahn 65 in Serie geschaltet. Die Spulen werden durch einen mäanderförmigen Leitungspfad 63 ausgebildet und sind auf unterschiedlichen Platinenlagen nahezu vollständig überlappend angeordnet. Die Spulen können auch vollständig überlappend auf der Platine 40 zueiandner angeordnet sein. Damit weisen beide Spulen nahezu die gleiche Gestalt auf, wodurch die induktive Belastung auf die jeweilige Leiterbahn 64, 65 ungefähr gleich groß ausfällt. Es kann auch nur eine der Leiterbahnen 64, 65 der differentiellen Leitung 61 mittels einer Induktivität 85 induktiv belastet werden. Damit ist es möglich, Unsymmetrien innerhalb der Leitungspfade 63 auszugleichen und die Einfügedämpfung und Rückflussdämpfung im Zusammenspiel mit den anderen Impedanzen und Leitungslängen zu optimieren.

Die induktive Belastung einer Leiterbahn 64, 65 kann auch durch Variation der Leiterbahnbreite, der Substratdicke oder dem Abstand der ersten und zweiten Leiterbahn verändert werden. Zudem können die Induktivitäten 85 als diskrete Bauteile ausgebildet sein.

Das zweite C 92 der C-L-C Kombination ist mit dem dritten Leiterbahnabschnitt L3 elektrisch verbunden. Das zweite C 92 ist vorzugsweise als Kondensator 80 ausgebildet, wobei der Kondensator 80 zwei leitende Flächen 82 aufweist. Die beiden leitenden Flächen 82 sind auf unterschiedlichen Platinenlagen nahezu vollständig überlappend zueinander angeordnet. Die leitenden Flächen 82 weisen dabei eine ähnliche Gestalt auf. Die erste leitende Fläche 84 dieses zweiten C 91 ist entlang einer elektrischen Verbindung weiter entfernt zu einem ersten Kontaktpad 46 angeordnet als die zweite leitende Fläche 84 dieses zweiten C 91 entlang einer elektrischen Verbindung zu einem ersten Kontaktpad 46. Die längere Wegstrecke, welche die erste leitende Fläche 84 des zweiten C 91 bis zu einem ersten Kontaktpad 46 entlang einer elektrischen Verbindung darstellt, ist bei der abgebildeten differentiellen Leitung 61 14,3 Millimeter lang, wohingegen die kürzere Wegstrecke 7,5 Millimeter lang ist. Damit ist die erste leitende Fläche 83 ca. 90 % der kürzeren Wegstrecke entlang einer elektrischen Verbindung weiter entfernt zu einem ersten Kontaktpad 46 angeordnet als die zweite leitende Fläche 84. Die Wegstreckendifferenz kann mehr oder weniger als die genannten absolut und prozentual Werte betragen. Die Wegstreckendifferenz beträgt jedoch mindesten 5 %.

Das zweite C 91 ist mit einem Anschluss 93 an einem zweiten Kontaktpad 59 der ersten Leiterbahn 64 und mit seinem anderen Anschluss 93 an den Leitungspfad 63 der zweiten Leiterbahn 65 angeschlossen. Das zweite C 91 kann mit einem Anschluss 93 am Leitungspfad 63 der ersten Leiterbahn 64 angeschlossen sein, wobei die erste leitende Fläche 83 durch Wahl des Anschlusspunktes des Anschlusses 93 an den Leitungspfad 63 oder durch die Länge des Anschlusses 93 stets weiter entfernt entlang einer elektrischen Verbindung zu einem ersten Kontaktpad 46 angeordnet ist, als die zweite leitende Fläche 84. Durch die unterschiedlichen Wegstrecken verschieben sich die jeweiligen induktiven und kapazitiven Anteile auf einer Leiterbahn 64, 65. Es steht ein weiterer Freiheitsgrad zur Verfügung um die Einfügedämpfung und Rückflussdämpfung zu verbessern. Zudem kann das zweite C 91 mit einem Anschluss 93 am zweiten Kontaktpad 59 und mit dem anderen Anschluss 93 ebenfalls an einem zweiten Kontaktpad 59 angeschlossen sein. Die Leitungsbreiten sind in den unterschiedlichen Leiterbahnabschnitten L1-L3 variabel gestaltbar.

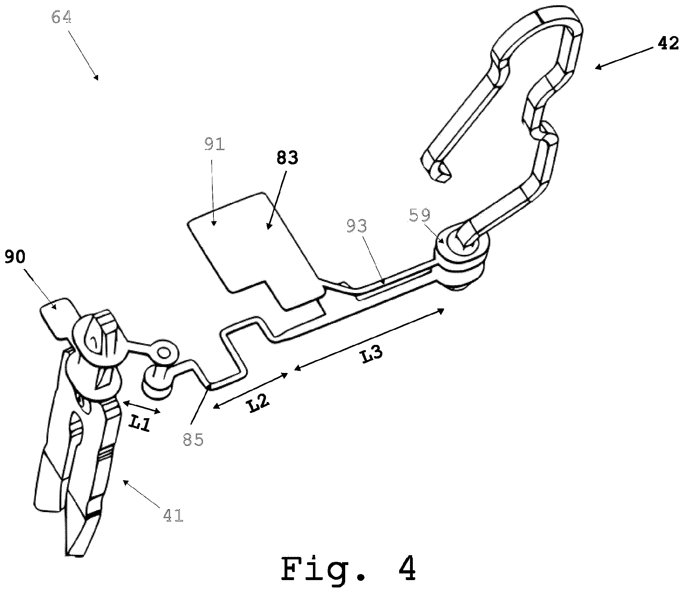

In Fig. 4 ist die erste Leiterbahn 64 der differentiellen Leitung 61 aus Fig. 3 abgebildet. Die erste leitende Fläche 83 des zweiten C 91 ist über einen Anschluss 93, welcher nicht zum Signalübertragungspfad gehört an den dritten Leiterbahnabschnitt L3, insbesondere an das zweite Kontaktpad 59 angeschlossen. Das zweite Kontaktpad 59 kann über mehrere Platinenlagen ausgebildet sein. Das zweite Kontaktpad 59 ist durch ein oder mehrere um die zweite Kontaktöffnung angeordnetes, kreisförmiges elektrisch leitendes Material ausgebildet. Für das erste Kontaktpad 46 gilt selbiges.

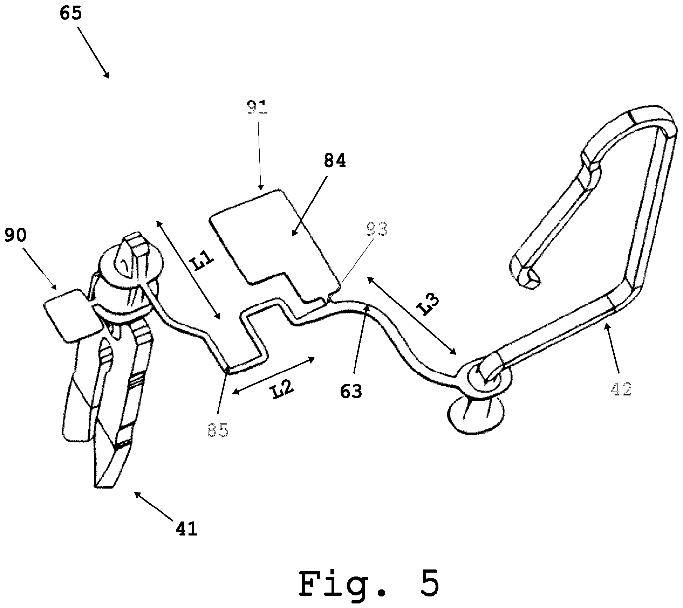

In Fig. 5 ist die zweite Leiterbahn 65 der differentiellen Leitung 61 aus Fig. 3 abgebildet. Die zweite leitende Fläche 84 des zweiten C 91 ist über seinen Anschluss 93 direkt mit dem Leitungspfad 63 der zweiten Leiterbahn 65 elektrisch verbunden.

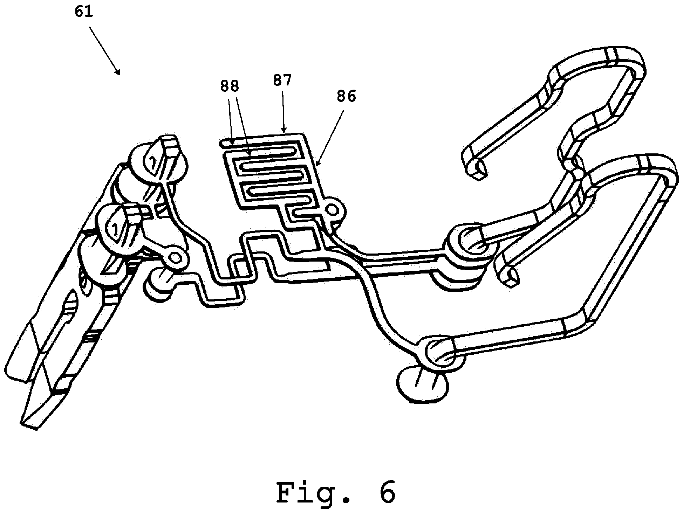

In Fig. 6 ist eine differentielle Leitung 61 aus Fig. 2 dargestellt, wobei der Plattenkondensator 81 durch einen Interdigitalkondensator 86 ersetzt wurde. Der Interdigitalkondensator 86 weist zwei voneinander isolierten Arme 87 auf, wobei die Arme 87 jeweils vier Stifte 88 aufweisen. Die Stifte 88 der beiden Arme 87 greifen abwechselnd ineinander ein. Der Interdigitalkondensator 86 ist auf einer Platinenlage ausgebildet. Der Interdigitalkondensator kann mehr oder weniger als vier Stifte 86 je Arm 87 aufweisen. Zusätzlich kann der Interdigitalkondensator 86 auf unterschiedlichen Platinenlagen ausgebildet sein.

### Bezugszeichenliste

- 1: Elektrischer Verbinder
- 2: Steckbuchse
- 10: Gehäuse
- 11: Vorderseite
- 12: Hinterseite
- 20: Gehäusevorderteil
- 21: Seitenflächen
- 22: Verbindungselement
- 23: Stab
- 24: Platte
- 30: Gehäusehinterteil
- 31: Seitenflächen
- 32: Einbuchtung
- 40: Platine
- 41: Erste Kontaktelemente
- 42: Zweite Kontaktelemente
- 43: Schneidklemmen
- 44: Fuß
- 45: Erste Kontaktöffnung
- 46: Erstes Kontaktpad
- 47: Durchführöffnung
- 48: Schneidfläche
- 49: Steckkontakte
- 50: Teilabschnitt eins
- 51: Teilabschnitt zwei
- 52: Teilabschnitt drei
- 53: Teilabschnitt vier
- 54: Zweite Kontaktöffnung
- 55: Erstes Verbindungselement
- 56: Zweites Verbindungselement
- 57: Drittes Verbindungselement
- 58: Kontaktstelle
- 59: Zweites Kontaktpad
- 60: Kompensationsleiterplatte
- 61: Differentielle Leitung
- 64, 65: Leiterbahn
- 63: Leiterpfad
- 64: Erste Leiterbahn
- 65: Zweite Leiterbahn
- 66: Via
- 70: Ladestück
- 71: Halteklemmen
- 72: Aushöhlungen
- 81: Plattenkondensator
- 82: Leitende Fläche
- 83: Erste leitende Fläche
- 84: Zweite leitende Fläche
- 85: Induktivität
- 86: Interdigitalkondensator
- 87: Arm
- 88: Stift
- 90: Erstes C
- 91: Zweites C
- 92: Stichleitung
- 93: Anschluss

- L: Längsachse
- Q: Querachse
- L1: Erster Leiterbahnabschnitt
- L2: Zweiter Leiterbahnabschnitt
- L3: Dritter Leiterbahnabschnitt

## Patentansprüche

1. Elektrischer Verbinder (1) für ein Daten- oder Kommunikationskabel mit folgenden Merkmalen:
- einem Gehäuse (10),
- einer im Gehäuse (10) zumindest teilweise angeordneten Platine (40),
- mit der Platine (40) sind erste (41) und zweite Kontaktelemente (42) verbunden,
- die Platine (40) weist mindestens eine differentielle Leitung (61) auf,
- die differentielle Leitung (61) weist eine erste (64) und eine zweite Leiterbahn (65) auf,
- das erste Kontaktelement (41) ist mit dem zweiten Kontaktelement (42) durch eine Leiterbahn (64, 65) verbunden,
- jede Leiterbahn (64, 65) weist einen Leitungspfad (63) sowie ein erstes (46) und ein zweites Kontaktpad (59) an den Enden des Leitungspfades (63) auf,
- mit der differentiellen Leitung (61) ist eine Kondensator-Induktivitäts-Kombination (kurz C-L-C Kombination) verschaltet,
- ein Kondensator (80) der C-L-C Kombination weist zwei zueinander isolierte leitende Flächen (82) auf,
**gekennzeichnet durch** das weitere Merkmal:
- ein Kondensator (80) der C-L-C Kombination ist mit seiner ersten leitenden Fläche (83) weiter entfernt zum ersten Kontaktpad (46) der ersten Leiterbahn (64) elektrisch angebunden als die zweite leitende Fläche (84) zum ersten Kontaktpad (46) der zweiten Leiterbahn (65).

2. Elektrischer Verbinder (1) nach einem der vorherigen Ansprüche, **dadurch gekennzeichnet, dass** der Kondensator (80) mit einem Anschluss (93) an einem zweiten Kontaktpad (59) der ersten Leiterbahn (64) und mit seinem anderen Anschluss (93) an den Leitungspfad (63) der zweiten Leiterbahn (65) angeschlossen ist.

3. Elektrischer Verbinder (1) nach einem der vorherigen Ansprüche, **dadurch gekennzeichnet, dass** die erste leitende Fläche (83) des Kondensators (80) entlang einer elektrischen Verbindung mindestens 5 %, vorzugsweise 20 %, besonders bevorzugt 50 %, ganz besonders bevorzugt 90 % der kürzeren Wegstrecke weiter entfernt zu einem ersten Kontaktpad (46) angeordnet ist als die zweite leitende Fläche (84) des Kondensators (80).

4. Elektrischer Verbinder (1) nach einem der vorherigen Ansprüche, **dadurch gekennzeichnet, dass** der Kondensator (80) als Plattenkondensator (81) ausgebildet ist, wobei der Plattenkondensator (81) zwei parallel zueinander angeordnete leitende Flächen (82) aufweist.

5. Elektrischer Verbinder (1) nach einem der vorherigen Ansprüche, **dadurch gekennzeichnet, dass** der Kondensator (80) als Interdigitalkondensator ausgebildet ist, wobei der Interdigitalkondensator erste Stifte und zweite Stifte aufweist, wobei die ersten Stifte und zweiten Stifte abwechselnd ineinander greifen.

6. Elektrischer Verbinder (1) nach einem der vorherigen Ansprüche, **dadurch gekennzeichnet, dass** die Induktivität (85) der C-L-C Kombination aus genau einer Induktivität (85) ausgebildet ist, wobei die Induktivität (85) mit dem Leitungspfad (63) der ersten Leiterbahn (64) oder mit dem Leitungspfad (63) der zweiten Leiterbahn (65) in Serie geschaltet ist.

7. Elektrischer Verbinder (1) nach einem der Ansprüche 1 bis 6, **dadurch gekennzeichnet, dass** die Induktivität (85) der C-L-C Kombination aus zwei voneinander räumlich getrennten Induktivitäten (85) ausgebildet ist, wobei die Induktivitäten (85) jeweils mit dem Leitungspfad (63) der ersten Leiterbahn (64) und der zweiten Leiterbahn (65) in Serie geschaltet sind.

8. Elektrischer Verbinder (1) nach Anspruch 6 oder 7, **dadurch gekennzeichnet, dass** die Induktivität (85) durch einen mäanderförmigen Verlauf des Leitungspfades (63) ausgebildet ist.

9. Elektrischer Verbinder (1) nach Anspruch 8, **dadurch gekennzeichnet, dass** der mäanderförmige Verlauf des Leitungspfades (63) der ersten Leiterbahn (64) auf einer Platinenlage angeordnet ist und der mäanderförmige Verlauf des Leitungspfades (63) der zweiten Leiterbahn (65) auf einer anderen Platinenlage angeordnet ist.

10. Elektrischer Verbinder (1) nach Anspruch 9, **dadurch gekennzeichnet, dass** der mäanderförmige Verlauf des Leitungspfades (63) der ersten (64) und zweiten Leiterbahnen (65) nahezu dieselbe Gestalt aufweisen, wobei die Verläufe nahezu vollständig überlappend zueinander angeordnet sind.

11. Elektrischer Verbinder (1) nach einem der Ansprüche 9 bis 10, **dadurch gekennzeichnet, dass** die Länge des mäanderförmigen Verlaufs des Leitungspfades (63) mindestens 20 % der Länge des Leitungspfades (63) ausmacht.

12. Elektrischer Verbinder (1) nach einem der vorherigen Ansprüche, **dadurch gekennzeichnet, dass** die Induktivität (85) durch Variation der Leiterbahnbreite, der Substratdicke oder dem Abstand der ersten und zweiten Leiterbahn veränderbar ist.

13. Elektrischer Verbinder (1) nach einem der vorherigen Ansprüche, **dadurch gekennzeichnet, dass** ein erstes C (90) in einem ersten Leiterbahnabschnitt (L1) angeordnet ist, wobei die Induktivität (85) in einem zweiten Leiterbahnabschnitt (L2) angeordnet ist, wobei das zweite C (91) in einem dritten Leiterbahnabschnitt (L3) angeordnet ist, wobei der erste Leiterbahnabschnitt (L1) das erste Kontaktpad (46) und den Leitungspfad (63) bis zur Induktivität (85) umfasst, wobei der zweite Leiterbahnabschnitt (L2) zwischen Anfang und Ende der in Serie geschalteten Induktivität (85) angeordnet ist, wobei der dritte Leiterbahnabschnitt (L3) das zweite Kontaktpad (59) und den Leitungspfad (63) von dem Ende der Induktivität (85) bis zum zweiten Kontaktpad (59) umfasst.

14. Elektrischer Verbinder (1) nach einem der vorherigen Ansprüche, **dadurch gekennzeichnet, dass** vier differentielle Leitungen (61) auf der Platine (40) ausgebildet sind.

15. Elektrischer Verbinder (1) nach einem der vorherigen Ansprüche, **dadurch gekennzeichnet, dass** das Gehäuse (10) zumindest teilweise aus einem leitenden Material ausgebildet ist.
